# EUROPEAN PATENT SPECIFICATION

(11) **EP 2 000 829 B1**
(45) Date of publication and mention of the grant of the patent: **11.09.2013**
(21) Application number: 07741063.7
(22) Date of filing: 29.03.2007
(51) Int. Cl.: G02F 1/1335, H01S 5/00, C04B 35/117, G02B 5/02

(54) **LIGHT TRANSMISSION SCATTERING MATERIAL AND ITS USE**
LICHTÜBERTRAGUNGSSTREUUNGSMATERIAL UND SEINE VERWENDUNG
MATERIAU DIFFUSANT LA LUMIERE ET UTILISATION DE CELUI-CI

(30) Priority: 30.03.2006 JP 2006093713
(43) Date of publication of application: 10.12.2008
(73) Proprietor: Ube Industries, Ltd., Ube-shi Yamaguchi 755-8633 (JP)
(72) Inventor: SAKATA, Shin-ichi, Ube-shi, Yamaguchi 755-8633 (JP); FURUUCHI, Fumito, Ube-shi, Yamaguchi 755-8633 (JP)
(74) Representative: Wössner, Gottfried
(86) International application number: PCT/JP2007/057627
(87) International publication number: WO 2007/114493

(56) References cited:
- EP-A1- 1 588 991
- EP-A2- 0 816 537
- JP-A- 2002 274 860
- JP-A- 2002 274 860
- JP-A- 2002 347 161
- JP-A- 2002 347 161
- JP-A- 2006 169 422
- JP-A- 2006 169 422
- JP-A- 2006 173 433
- JP-A- 2006 173 433
- R. VICTOR JONES: "Light scattering in ceramics", SPIE, vol. 362, 1983, pages 2-8, XP002663581,
- "LED Backlight changes color of Television", NIKKEI ELECTRONICS, NIKKEI BUSINESS PUBLICATIONS, TOKYO, JP, 20 December 2004 (2004-12-20), pages 57-62, XP008145240, ISSN: 0385-1680
- KAWANASHI H ET AL: "Eye-Safe Semiconductor Laser for Ultrahigh-Speed IrDA (UFIR)", SHAPU GIHO / SHARP TECHNICAL JOURNAL, SHARP CO., NARA-KEN, JP, no. 87, 1 December 2003 (2003-12-01), pages 15-20, XP008145239, ISSN: 0285-0362

## Description

### TECHNICAL FIELD

The present invention relates to using a light-transmitting scatterer, such as in a backlight structure of liquid crystal displays and in an eye-safe semiconductor laser.

### BACKGROUND ART

In recent years, the need for an element that scatters light is growing. For example, studies are being made to use red, green and blue light-emitting diodes as the backlight of a liquid crystal display, and the use as a backlight requires uniform mixing of lights from red, green and blue light-emitting diodes. A light scatterer is utilized for realizing this uniform mixing. In order to produce a brighter backlight, a light scatterer assured of small light absorption and excellent in durability against light, as well as heat resistance is being demanded (see, Leading Trends, "LED Backlight Changes "Color" of Television", pp. 57-62, Nikkei Electronics, December 20, 2004).

In recent years, aggressive research and development of a white light-emitting diode are proceeding, where a light scattering element for uniformly mixing yellow and other lights emitted from fluorescent materials with excellent light of blue is necessary. At present, this is realized by dispersing a light-scattering agent in a resin and utilizing scattering therein, also here, in order to obtain brighter light, a light scatterer assured of minimized attenuation of light and excellent in the durability against light and stability to heat is being demanded.

Furthermore, new usage of the light-scattering element includes an eye-safe semiconductor laser for ultrahigh-speed communications, development of which is recently ongoing. Use of laser light for communication enables fast modulation and instantaneous transfer of large-volume data, but laser light that enters an eye is very dangerous and is as an obstacle to its application. Therefore, laser light is scattered and the light power is dispersed, whereby an eye-safe laser is realized. At present, development is being made with a resin having mixed therein a light-scattering agent, but similarly to the above-described cases, it is thought that a light scatterer assured of less light attenuation and long-term durability is demanded in the future (see, Kawanishi et al., "Eye-Safe Semiconductor Laser for Ultrahigh-Speed IrDA (UFIR)" (Sharp Giho (Sharp Technical Report), No. 87, pp. 15-20, December 2003), Non-Patent Document 2).

In this way, utilization of a material that scatters light is starting to become diversified. Production of a material that scatters light is not difficult. For example, such a material can be obtained by mixing a resin with a powder or the like differing in the refractive index from the resin. However, in a light scattering element where such a powder is dispersed, absorption of light repeatedly occurs due to a defect on the powder surface and there arises a problem that light attenuation becomes large. When a resin is used for the element, this may cause a problem in durability against light and stability. In order to solve these problems, a light-scattering material assured of small light absorption and high light stability or heat resistance is demanded. EP 1 588 991 discloses a ceramic which is excellent in brightness, heat resistance and ultraviolet light resistance, without stating any scattering properties.

An object of the present invention is to provide a use of a light scatterer with high heat resistance, small light absorption and high light stability or heat resistance, and a backlight structure, an eye-safe semiconductor using the light scatterer.

### DISCLOSURE OF THE INVENTION

The present inventors have found that a light scatterer using a ceramic composite comprising a solidified body in which two or more oxide phases selected from a single metal oxide and a complex metal oxide and different at least in the refractive index are formed to be continuously and three-dimensionally entangled with each other becomes a light-scattering element small in the light absorption and excellent in the light stability and heat resistance. The present invention has been accomplished based on this finding.

In other words, the present invention provides the following: the use of a light-transmitting scatterer according to claim 1, a backlight structure according to claim 9 and an eye-safe semiconductor laser according to claim 10.

When the above-cited light scatterer is used, a light scatterer assured of small light absorption, excellent light stability and high heat resistance as compared with a conventionally employed light scatterer using a resin, and a backlight structure, an eye-safe semiconductor laser and the like using the light scatterer, can be produced.

### BRIEF DESCRIPTION OF THE DRAWINGS

Fig. 1 shows one example of the texture photograph of the present light-transmitting scatterer
Fig. 2A shows one example of the transmitting electron micrograph of the interface in the present composite ceramic, and Fig. 2B shows one example of the transmitting electron micrograph of the interface in a sintered body.
Fig. 3 shows a cross-section of a light scatterer obtained by dispersing an inorganic powder in a resin.
Fig. 4 shows a measuring method using an integrating sphere for measuring the transmitted light.
Fig. 5 shows the transmittance of Example 1 and Comparative Examples 1 and 2 as measured by the measuring method shown in Fig. 4.
Fig. 6 shows a method for measuring light scattering.
Fig. 7 shows the luminous flux of Example 1 and Comparative Examples 1 and 2 as measured by the measuring method shown in Fig. 6.
Fig. 8 shows an example where the present light-transmitting scatterer is used for color mixing of a backlight of a liquid crystal panel.
Fig. 9 shows an example of an eye-safe semiconductor laser where the present light-transmitting scatterer is combined with a semiconductor laser.

### BEST MODE FOR CARRYING OUT THE INVENTION

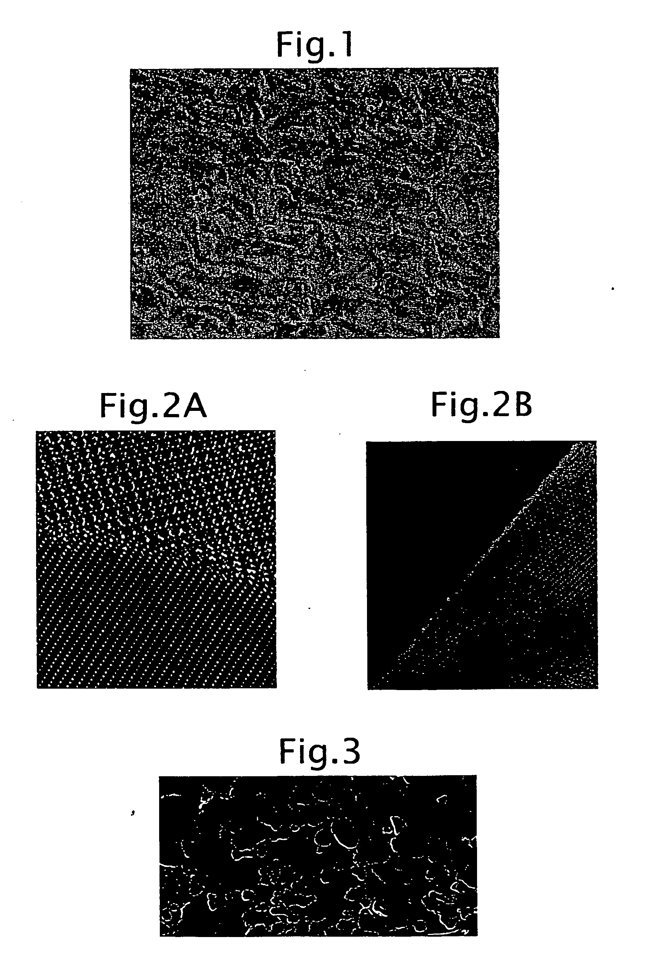

The present light scatterer comprises a ceramic composite in which two or more oxide phases selected from a single metal oxide and a complex metal oxide and different at least in the refractive index are formed to be continuously and three-dimensionally entangled with each other. Fig. 1 shows one example of the texture photograph in the cross-section of such a ceramic composite by a scanning electron microscope. The black portion (dark portion) is a first crystal phase and the gray portion (bright portion) is a second crystal phase. These two phases differ in the refractive index and therefore, light injected causes refraction and reflection at the interface between the first crystal and the second crystal. Moreover, since the interface of two phases is extending in various directions, the light is released at every angles. This is effected in the three-dimensional texture of the ceramic composite and therefore, the ceramic composite becomes an excellent light scatterer. Such property substantially differs from that of a light scatterer produced by forming irregularities on the surface of a transparent substance such as glass and resin. The light scatterer such as glass and resin utilizes light scattering on the surface, but the present light scatterer effects light scattering also in the inside of the material.

The refractive index difference is not particularly limited but is preferably 0.01 or more, more preferably 0.05 or more, still more preferably 0.07 or more, yet still more preferably 1.00 or more. As the refractive index difference is larger, the light scattering efficiency is advantageously higher, but the refractive index difference realizable in a ceramic composite is the upper limit value.

One of features of this light scatterer is small light attenuation. The characteristics of the interface between those oxide phases seem to greatly contribute to this feature. Fig. 2A shows one example of the transmitting electron micrograph of the interface between two crystal phases in this light scatterer. For comparison, one example of the interface (grain boundary) between two crystal phases in a sintered body having the same composition is shown together in Fig. 2B. In the photograph of a sintered body of Fig. 2B, the white beltlike portion in the center part is the grain boundary of crystal phases. A crystal lattice is not observed and this reveals that the portion is an amorphous layer where atoms are disordered. The presence of such a layer is not preferred, because defects by the atomic disorder give rise to light absorption. On the other hand, in the ceramic composite shown in Fig. 2A, which is the present light scatterer, an amorphous layer seen in a sintered body is not observed. Moreover, atoms are regularly arrayed even in the interface and the number of defects in the interface of the ceramic composite is considered to be smaller than in a sintered body. Accordingly, this material is greatly reduced in the light attenuation.

Another feature of the present light scatterer is that light is readily diffused in the light scatterer. This feature is also attributable to the property of the ceramic composite where two or more oxide phases are continuously and three-dimensionally entangled with each other. That is, the present light scatterer is characterized in that the crystal phases are continuing and therefore, the light injected is waveguided through the crystals and diffuses in the inside of the material. By virtue of this feature, unlike a light scatterer produced from a resin having dispersed therein a powder, where light abruptly attenuates with distance from the portion irradiated with light, the present light scatterer allows light to be waveguided even in a place distant from the light irradiated portion and causes less attenuation of light. This provides an effect that the light irradiated area is enlarged by the present light scatterer, and in turn, wide spread of light can be attained.

A very important feature of the present light scatterer is that two or more oxide crystal phases are each not independent but are integrated to establish an integral relationship. For example, in a light scatterer composed of an Al₂O₃ crystal and a Y₃Al₅O₁₂ crystal, two crystals are not merely present but an Al₂O₃ crystal and a Y₃Al₅O₁₂ crystal are simultaneously crystallized from one kind of a melt having a composition which is neither Al₂O₃ nor Y₃Al₅O₁₂, as a result, two crystals are allowed to be present, which differs from the case where two crystals are independently present. Accordingly, the light scatterer has features such as lack of distinct grain boundary. This light-scattering element substantially differs from the sintered body-like state where Al₂O₃ and Y₃Al₅O₁₂ crystals are merely mixed.

Finally, this light scatterer is compared with a light scatterer obtained by dispersing an inorganic powder in a resin. Fig. 3 shows a cross-section of a light scatterer obtained by dispersing a powder in a resin. In this light scatterer, when light enters into the powder from the surface or goes out therefrom, the light is absorbed by surface defects of the powder. Also, incident light into and outgoing light from the particle surface are multiplexed due to scattering and reflection on the powder surface and therefore, the surface has a very large effect. In this way, in a resin containing a light-scattering agent like powder, the light is significantly attenuated. Also, the light scatterer using a resin cannot be used for scattering light in the ultraviolet region, because light absorption by the resin starts in the ultraviolet region. On the other hand, the present light scatterer is composed of a ceramic and can be utilized as a light scatterer also in the ultraviolet region by selecting an appropriate composition system

As described above, the present light-transmitting scatterer becomes a light scatterer having excellent light transparency and effecting great light scattering by virtue of the construction where two or more crystal phases differing in the refractive index are continuously and three-dimensionally entangled with each other. For example, the present light-transmitting scatterer has light-scattering characteristics as described above, nevertheless, can exhibit a transmittance for visible light of 30% or more, particularly 40% or more, more particularly 50% or more.

### (Production Method)

The present light scatterer is produced by melting raw material metal oxides and solidifying the melt. The solidified body may be obtained, for example, by a simple and easy method where the melt charged into a crucible kept at a predetermined temperature is congealed under cooling while controlling the cooling temperature, but a unidirectional solidification method is most preferred. The process thereof is roughly as follows.

Metal oxides working out to raw materials are mixed in a ratio giving desired component percentages to prepare a mixed powder. The mixing method is not particularly limited and either a dry mixing method or a wet mixing method may be employed. Subsequently, the mixed powder is heated and melted at a temperature of causing the charged raw materials to melt by using a known melting furnace such as arc melting furnace.

The obtained melt is directly charged into a crucible and subjected to unidirectional solidification. Alternatively, the melt is once solidified and then ground, the ground product is charged into a crucible and again heated and melted, and the crucible containing the melt is withdrawn from the heating zone of the melting furnace and subjected to unidirectional solidification. The unidirectional solidification of the melt may be performed under ordinary pressure but for obtaining a material where the crystal phase is reduced in the defect, the unidirectional solidification is preferably performed under a pressure of 4,000 Pa or less, more preferably 0.13 Pa (10⁻³ Torr) or less.

The withdrawing rate of the crucible from the heating zone, that is, the solidification rate of the melt, is set to an appropriate value according to the melt composition and melting conditions but is usually 50 mm/hour or less, preferably from 1 to 20 mm/hour.

As regards the apparatus for unidirectional solidification, an apparatus which itself is known may be used, where a crucible is vertically movably housed in a cylindrical container disposed in the vertical direction, an induction coil for heating is fixed to the central outer side of the cylindrical container, and a vacuum pump for depressurizing the space in the container is disposed.

A block in a necessary shape is cut out from the resulting solidified body and used as a light scatterer.

As for the oxide species forming the solidified body, various combinations may be employed, but a ceramic selected from the group consisting of a metal oxide and a complex metal oxide produced from two or more kinds of metal oxides is preferred. Examples of the metal oxide include aluminum oxide (Al₂O₃), zirconium oxide (ZrO₂), magnesium oxide (MgO), silicon oxide (SiO₂), titanium oxide (TiO₂), barium oxide (BaO), beryllium oxide (BeO), calcium oxide (CaO), chromium oxide (Cr₂O₃) and rare earth element oxides (La₂O₃, Y₂O₃, CeO₂, Pr₆O₁₁, Nd₂O₃, Sm₂O₃, Gd₂O₃, Eu₂O₃, Tb₄O₇, DY₂O₃, Ho₂O₃, Er₂O₃, Tm₂O₃, Yb₂O₃ and Lu₂O₃). Examples of the complex metal oxide produced from these metal oxides include LaAlO₃, CeAlO₃, PrAlO₃, NdAlO₃, SmAlO₃, EuAlO₃, GdAlO₃, DyAlO₃, ErAlO₃, Yb₄Al₂O₉, Y₃Al₅O₁₂, Er₃Al₅O₁₂, 11Al₂O₃•La₂O₃, 11Al₂O₃•Nd₂O₃, 3Dy₂O₃•5Al₂O₃, 2Dy₂O₃•Al₂O₃, 11Al₂O₃•Pr₂O₃, EuAl₁₁O₁₈, 2Gd₂O₃•Al₂O₃, 11Al₂O₃•Sm₂O₃, Yb₃Al₅O₁₂, CeAl₁₁O₁₈ and Er₄Al₂O₉.

Among these, a combination of Al₂O₃ and a rare earth element oxide is preferred, because a material excellent not only in the optical properties but also in the mechanical properties is obtained. Also, as described later, a composite material where respective crystal phases are three-dimensionally and continuously entangled is easily obtained by the unidirectional solidification method. In particular, a composite material composed of two phases Al₂O₃ and Y₃Al₅O₁₂, produced from Al₂O₃ and Y₂O₃, is preferred.

This light-transmitting scatterer causes no light scattering on the powder surface as in a light scatterer obtained by mixing a powder and a resin and therefore, can efficiently scatter the light with high light transparency. Furthermore, this light-transmitting scatterer is a ceramic material having a high melting point and therefore, is endowed with very high optical, thermal and chemical stability and unlike a resin material, free of a problem in the heat resistance or occurrence of deterioration due to light.

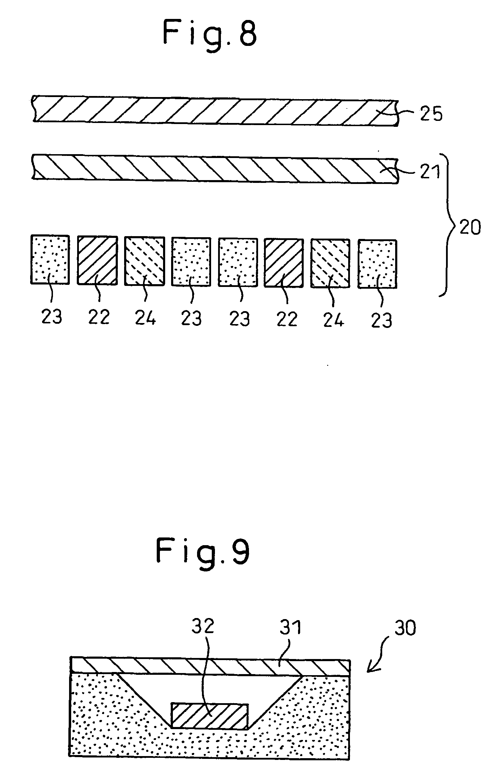

The present light-transmitting scatterer is useful for the usage where various light-transmitting scatterers are used. For example, referring to Fig. 8, the light-transmitting scatterer is used as a light scatterer 21 for the color mixing of a backlight of a liquid crystal display 25 having a red light-emitting diode 22, a green light-emitting diode 23 and a blue light-emitting diode 24, whereby a backlight structure 20 can be fabricated. When the present light scatterer is used, waveguiding and scattering of light are repeated in a texture where single crystals are entangled, as a result, a more uniform white color than by a normal diffuser utilizing surface scattering can be obtained. In the case of using a normal diffuser, unevenness increases due to intense light directly above the light source and in order to avoid this, a transparent sheet having printed thereon a pattern for controlling the luminous flux is disposed. On the other hand, the present light scatterer allows for large waveguiding in the transverse direction and this leads to decrease in the unevenness of light, so that the sheet can be dispensed with. Also, color mixing is effectively performed, so that the space for mixing lights can be narrowed and a thin backlight can be fabricated.

Also, referring to Fig. 9, an eye-safe semiconductor laser 30 can be fabricated by combining a light scatterer 31 and a semiconductor laser 32. The light injected into the laser is waveguided and spread in the transverse direction in the present light scatterer. A normal resin having dispersed therein a powder takes a Lambertian light distribution, whereas when the present light scatterer is used, the laser light spreads at a higher scattering angle, as a result, an eye-safe laser with higher safety can be realized. Moreover, the light scatterer uses no resin and therefore, is assured of sufficient durability against intense light such as laser light.

### EXAMPLES

The present light scatterer is described in greater detail by referring specific examples.

### Example 1:

An α-Al₂O₃ powder (purity: 99.99%) and a Y₂O₃ powder (purity: 99.999%) were weighed in a mixing ratio of 82:18 by mol, these powders were wet mixed in ethanol by a ball mill for 16 hours, and the ethanol was then removed using an evaporator to obtain a raw material powder. This raw material powder was subjected to preparatory melting in a vacuum furnace and used as a raw material for unidirectional solidification.

Subsequently, this raw material was charged into a molybdenum crucible and after setting the crucible in a unidirectional solidification apparatus, the raw material was melted under a pressure of 1.33×10⁻³ Pa (10⁻⁵ Torr). In the same atmosphere, the crucible was moved down at a speed of 5 mm/hour to obtain a solidified body. The solidified body obtained was translucent and white.

Fig. 1 shows a cross-sectional texture perpendicular to the solidification direction of the solidified body. The white portion is the Y₃Al₅O₁₂ phase and the black portion is the Al₂O₃ phase. The volume fraction of Y₃Al₅O₁₂:Al₂O₃ was 55:45. The refractive index of Y₃Al₅O₁₂ is about 1.83, the refractive index of Al₂O₃ is about 1.77, and in proportion to the ratio between these refractive indexes, refraction of light occurs according to the Snell's law. Reflection occurs at the same time and the refracted or reflected light is similarly refracted or reflected at another interface. With this repetition, light spreads in the solidified body, which determines the property of the light scatterer.

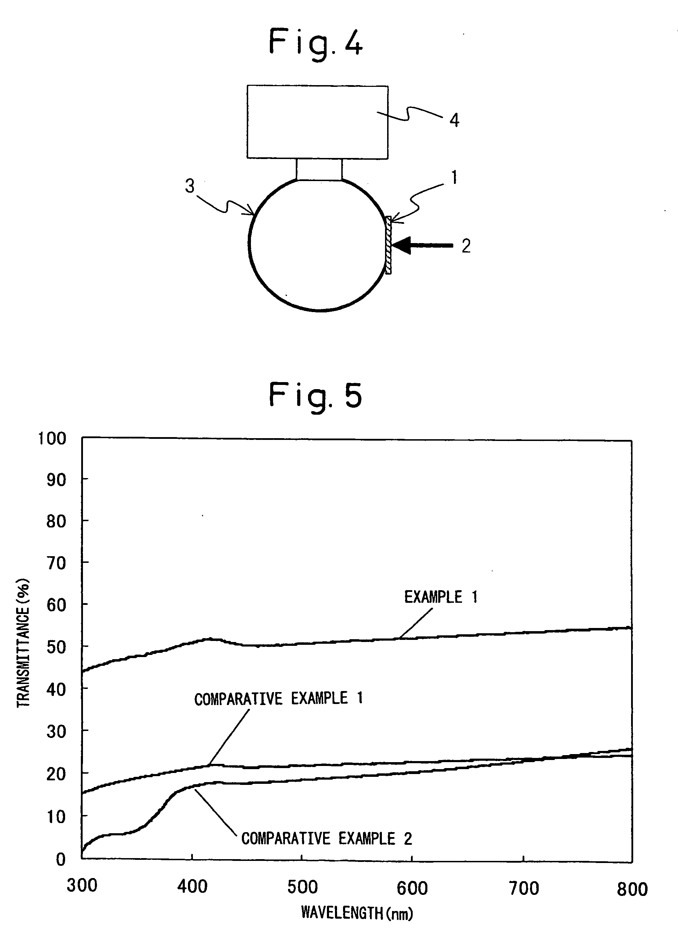

From the solidified body, a 0.2 mm-thick plate was cut out in the direction perpendicular to the solidification direction to produce a light scatterer. In preparation for the measurement, this light scatterer was placed before a light source, as a result, scattering of light was confirmed with an eye. Then, the intensity of light transmitted through this material was measured by the measuring method using an integrating sphere shown in Fig. 4. That is, light 2 transmitted through a sample 1 was detected by a detector (photoelectric doubling tube) 4 through an integrating sphere 3.

Fig. 5 shows the measurement results. In Fig. 5, the transmittance of a 0.2 mm-thick plate of Comparative Example 2 obtained by dispersing a YAG powder in a resin, and the transmittance of a 0.2 mm-thick plate of Comparative Example 1 which is a sintered body having the same composition as in Example 1 are shown together. The transmittance of the present light-transmitting scatterer (ceramic composite) is nearly about 50% in the visible light region, and it was found that the transmittance is very good as compared with the sintered body of Comparative Example 1 (about 21%) or the powder-dispersed resin of Comparative Example 2 (about 18%). Furthermore, in the light scatterer using the resin of Comparative Example 2, absorption starts in the ultraviolet region at a wavelength shorter than 400 nm, whereas in the light scatterer of Example 1, sufficient light is transmitted even in the wavelength region shorter than 400 nm, revealing that this scatterer can be utilized as a light scatterer also in the ultraviolet region.

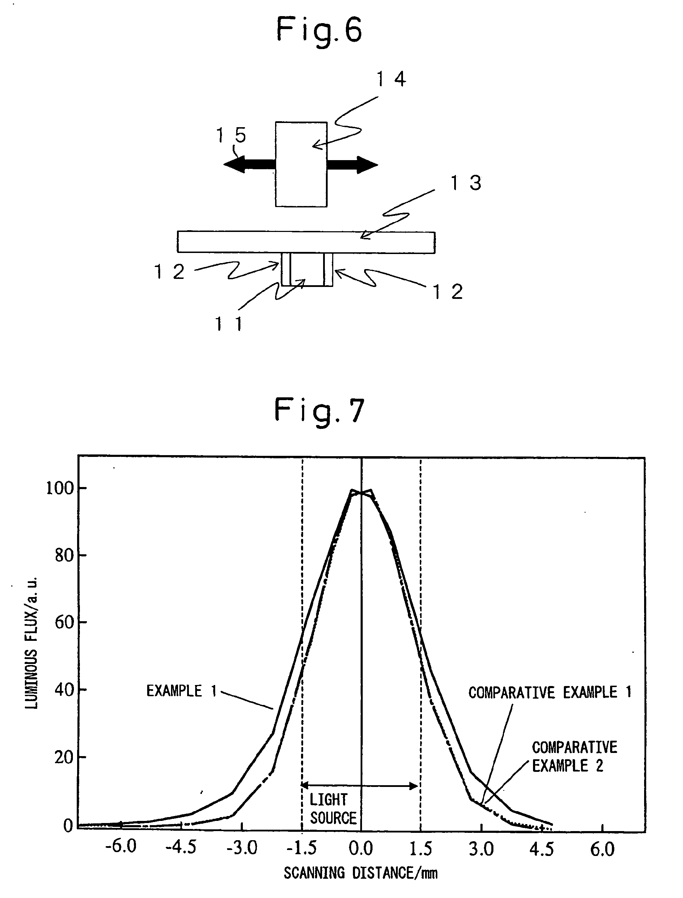

Furthermore, characteristics of this light scatterer were studied. Fig. 6 shows the measuring apparatus. A 3.0 mm-square light source 11 provided with a light-shielding plate 12 was put into tight contact with a 0.2 mm-thick ceramic composite (sample) 13 of Example 1, and the luminous flux of light on the transmission surface was examined by scanning a detector 14 in the horizontal direction. Fig. 7 shows the results. In Fig. 7, for comparison, measurement results of the sintered body of Comparative Example 1 and the light scatterer of Comparative Example 2 obtained by dispersing a YAG powder in a resin are shown together. Also, for enabling comparison of the peak shape, the value was normalized by taking the luminous flux of light directly above the center part of the light source as 100. The peak shapes of Comparative Examples 1 and 2 were utterly the same. The light scatterer of Example 1 exhibited a larger luminous flux than those of Comparative Examples 1 and 2 at all positions. In particular, it could be confirmed that attenuation of the luminous flux with distance from the light source is reduced and light spreads in the sample plane through the light scatterer of Example 1. Accordingly, the light scatterer of Example 1 is more excellent in the light scattering effect than the light scatterers of Comparative Examples 1 and 2. Also, the peak shape of Example 1 is different from the normalized peak shapes of Comparative Examples 1 and 2 which are utterly the same, and it is revealed that the light propagation mode of the light scatterer of Example 1 differs from the light propagation style of Comparative Examples 1 and 2. This difference is considered to be attributable to the fact that light propagates like waveguide propagation through crystals where two-phase crystals are three-dimensionally and complicatedly entangled.

### Comparative Example 1:

The same raw material powders as in Example 1 were filled in a graphite-made die and press-sintered at 1,700°C and a surface pressure of 50 MPa for 2 hours in an atmosphere of 1.33 Pa (10⁻² Torr) to obtain a sintered body.

From the center part of the sintered body obtained, a 0.2 mm-thick plate was cut out in the same manner as in Example 1. The light transmitted through this material was measured by the same method as in Example 1, and Fig. 5 shows the results. The light transmittance was about 20%.

Subsequently, light scattering characteristics were examined by the same method as in Example 1. Fig. 7 shows the results.

### Comparative Example 2:

An epoxy resin and a commercially available YAG powder were mixed at 87:13 by volume, and the mixture was cured at 150°C for 10 hours to produce a lump of the resin having dispersed therein the powder. A 0.2 mm-thick plate was cut out from the lump in the same manner as in Example 1, and the transmitted light was measured by the same method as in Example 1.

Fig. 5 shows the results. The light transmittance was about 20%.

Subsequently, light scattering characteristics were examined by the same method as in Example 1. Fig. 7 shows the results.

### Example 2:

As shown in Fig. 8, the light scatterer of Example 1 was used as the light scatterer for color mixing of a liquid crystal backlight having red, green and blue light-emitting diodes, as a result, a uniform white color could be obtained. Moreover, a very bright display could be obtained as compared with the case using the light scatterer of Comparative Example 1 or 2. The backlight structure of the present invention can be made thin by omitting a conventional transparent sheet having printed thereon a pattern for controlling the luminous flux.

### Example 3:

The light scatterer of Example 1 was, as shown in Fig. 9, combined with a semiconductor laser, whereby an eye-safe semiconductor laser could be fabricated. The light efficiency of the eye-safe semiconductor laser of the present invention was high as compared with the case using the light scatterer of Comparative Example 1 or 2. Also, the scattering angle was wider and the safety was higher than in the case using the light scatterer of Comparative Example 1 or 2.

### INDUSTRIAL APPLICABILITY

The present light-transmitting scatterer is a light scatterer having high heat resistance, small light absorption and high light stability and being useful in a backlight structure, in an eye-safe semiconductor laser and therefore, is industrially applicable.

## Claims

1. Use of a light-transmitting scatterer (21; 31) in a backlight structure (20) of a liquid crystal display (25) comprising red, green and blue light-emitting diodes (22, 23, 24) and the light-transmitting scatterer (21), or in an eye-safe semiconductor laser (30) comprising a semiconductor laser (32) and the light-transmitting scatterer (31), **characterized in that** said light-transmitting scatterer (21; 31) comprises a solidified body in which two or more oxide phases selected from a group consisting of a single metal oxide and a complex metal oxide, produced from two or more kinds of metal oxides, and different at least in the refractive index are formed to be continuously and three-dimensionally entangled with each other.

2. The use of a light-transmitting scatterer (21; 31) as claimed in claim 1, wherein the boundary portion between constituent phases does not have an amorphous phase.

3. The use of a light-transmitting scatterer (21; 31) as claimed in claim 1 or 2, wherein the oxide phases comprise Al₂O₃ and Y₃Al₅O₁₂.

4. The use of a light-transmitting scatterer (21; 31) as claimed in any one of claims 1 to 3, which is obtained by a unidirectional solidification method.

5. The use of a light-transmitting scatterer (21; 31) as claimed in any one of claims 1 to 4, wherein the light transmittance for visible light is 30% or more.

6. The use of a light-transmitting scatterer (21; 31) as claimed in any one of claims 1 to 5, which is in a plate form.

7. The use of a light-transmitting scatterer (21; 31) as claimed in any one of claims 1 to 5, which is in a block form.

8. The use of a light-transmitting scatterer (21; 31) as claimed in any one of claims 1 to 7, wherein said refractive index difference is 0.01 or more.

9. A backlight structure (20) of a liquid crystal display (25), comprising red, green and blue light-emitting diodes (22, 23, 24) and a light-transmitting scatterer (21), **characterized in that** said light-transmitting scatterer (21) comprises a solidified body in which two or more oxide phases selected from a group consisting of a single metal oxide and a complex metal oxide, produced from two or more kinds of metal oxides, and different at least in the refractive index are formed to be continuously and three-dimensionally entangled with each other.

10. An eye-safe semiconductor laser (30) comprising a semiconductor laser (32) and a light-transmitting scatterer (31), **characterized in that** said light-transmitting scatterer (31) comprises a solidified body in which two or more oxide phases selected from a group consisting of a single metal oxide and a complex metal oxide, produced from two or more kinds of metal oxides, and different at least in the refractive index are formed to be continuously and three-dimensionally entangled with each other.

## Patentansprüche

1. Verwendung einer lichtdurchlässigen Lichtstreuungsvorrichtung (21; 31) in einer Hinterleuchtungsstruktur (20) einer Flüssigkristallanzeige (25), die rote, grüne und blaue Leuchtdioden (22, 23, 24) und die lichtdurchlässige Lichtstreuungsvorrichtung (21) umfasst, oder in einem augensicheren Halbleiterlaser (30), der einen Halbleiterlaser (32) und die lichtdurchlässige Lichtstreuungsvorrichtung (31) umfasst, **dadurch gekennzeichnet, dass** die lichtdurchlässige Lichtstreuungsvorrichtung (21; 31) einen verfestigten Korpus umfasst, in dem zwei oder mehr Oxidphasen, die aus einer Gruppe ausgewählt sind, die aus einem einzelnen Metalloxid und einem komplexen Metalloxid, das aus zwei oder mehr Arten von Metalloxiden hergestellt ist, besteht, und sich mindestens im Brechungsindex unterscheiden, so ausgebildet sind, dass sie kontinuierlich und dreidimensional miteinander verflochten sind.

2. Verwendung einer lichtdurchlässigen Lichtstreuungsvorrichtung (21; 31) nach Anspruch 1, wobei der Grenzabschnitt zwischen einzelnen Phasen keine amorphe Phase aufweist.

3. Verwendung einer lichtdurchlässigen Lichtstreuungsvorrichtung (21; 31) nach Anspruch 1 oder 2, wobei die Oxidphasen Al₂O₃ und Y₃Al₅O₁₂ enthalten.

4. Verwendung einer lichtdurchlässigen Lichtstreuungsvorrichtung (21; 31) nach einem der Ansprüche 1 bis 3, die durch ein unidirektionales Verfestigungsverfahren erhalten wird.

5. Verwendung einer lichtdurchlässigen Lichtstreuungsvorrichtung (21; 31) nach einem der Ansprüche 1 bis 4, wobei der Lichtdurchlässigkeitsgrad für sichtbares Licht mindestens 30 % beträgt.

6. Verwendung einer lichtdurchlässigen Lichtstreuungsvorrichtung (21; 31) nach einem der Ansprüche 1 bis 5, die eine Plattenform aufweist.

7. Verwendung einer lichtdurchlässigen Lichtstreuungsvorrichtung (21; 31) nach einem der Ansprüche 1 bis 5, die eine Blockform aufweist.

8. Verwendung einer lichtdurchlässigen Lichtstreuungsvorrichtung (21; 31) nach einem der Ansprüche 1 bis 7, wobei die Brechungsindexdifferenz mindestens 0,01 beträgt.

9. Hinterleuchtungsstruktur (20) einer Flüssigkristallanzeige (25), die rote, grüne und blaue Leuchtdioden (22, 23, 24) und eine lichtdurchlässige Lichtstreuungsvorrichtung (21) umfasst, **dadurch gekennzeichnet, dass** die lichtdurchlässige Lichtstreuungsvorrichtung (21) einen verfestigten Korpus umfasst, in dem zwei oder mehr Oxidphasen, die aus einer Gruppe ausgewählt sind, die aus einem einzelnen Metalloxid und einem komplexen Metalloxid, das aus zwei oder mehr Arten von Metalloxiden hergestellt ist, besteht, und sich mindestens im Brechungsindex unterscheiden, so ausgebildet sind, dass sie kontinuierlich und dreidimensional miteinander verflochten sind.

10. Augensicherer Halbleiterlaser (30), der einen Halbleiterlaser (32) und eine lichtdurchlässige Lichtstreuungsvorrichtung (31) umfasst, **dadurch gekennzeichnet, dass** die lichtdurchlässige Lichtstreuungsvorrichtung (31) einen verfestigten Korpus umfasst, in dem zwei oder mehr Oxidphasen, die aus einer Gruppe ausgewählt sind, die aus einem einzelnen Metalloxid und einem komplexen Metalloxid, das aus zwei oder mehr Arten von Metalloxiden hergestellt ist, besteht, und sich mindestens im Brechungsindex unterscheiden, so ausgebildet sind, dass sie kontinuierlich und dreidimensional miteinander verflochten sind.

## Revendications

1. Utilisation d'un diffuseur transmettant la lumière (21 ; 31) dans une structure de rétroéclairage (20) d'un afficheur à cristaux liquides (25) comprenant des diodes électroluminescentes rouge, verte et bleue (22, 23, 24) et le diffuseur transmettant la lumière (21), ou dans un laser à semi-conducteurs sans danger pour les yeux (30) comprenant un laser à semi-conducteurs (32) et le diffuseur transmettant la lumière (31), **caractérisée en ce que** ledit diffuseur transmettant la lumière (21 ; 31) comprend un corps solidifié dans lequel deux phases ou plus d'un oxyde sélectionné dans un groupe comprenant un oxyde métallique unique et un oxyde métallique complexe, produit à partir de deux types ou plus d'oxydes métalliques, et qui diffèrent au moins quant à l'indice de réfraction, sont formées de manière à être enchevêtrées de façon continue et tridimensionnelle les unes avec les autres.

2. Utilisation d'un diffuseur transmettant la lumière (21 ; 31) selon la revendication 1, dans laquelle la partie de frontière entre les phases constitutives ne comporte pas de phase amorphe.

3. Utilisation d'un diffuseur transmettant la lumière (21 ; 31) selon la revendication 1 ou 2, dans laquelle les phases d'oxyde comprennent du Al₂O₃ et du Y₃Al₅O₁₂.

4. Utilisation d'un diffuseur transmettant la lumière (21 ; 31) selon l'une quelconque des revendications 1 à 3, qui est obtenu par un procédé de solidification unidirectionnelle.

5. Utilisation d'un diffuseur transmettant la lumière (21 ; 31) selon l'une quelconque des revendications 1 à 4, dans laquelle la transmittance de la lumière pour la lumière visible est de 30 % ou plus.

6. Utilisation d'un diffuseur transmettant la lumière (21 ; 31) selon l'une quelconque des revendications 1 à 5, qui a une forme de plaque.

7. Utilisation d'un diffuseur transmettant la lumière (21 ; 31) selon l'une quelconque des revendications 1 à 5, qui a une forme de bloc.

8. Utilisation d'un diffuseur transmettant la lumière (21 ; 31) selon l'une quelconque des revendications 1 à 7, dans laquelle ladite différence d'indice de réfraction est de 0,01 ou plus.

9. Structure de rétroéclairage (20) d'un afficheur à cristaux liquides (25), comprenant des diodes électroluminescentes rouge, verte et bleue (22, 23, 24) et un diffuseur transmettant la lumière (21), **caractérisée en ce que** ledit diffuseur transmettant la lumière (21) comprend un corps solidifié dans lequel deux phases ou plus d'un oxyde sélectionné dans un groupe comprenant un oxyde métallique unique et un oxyde métallique complexe, produit à partir de deux types ou plus d'oxydes métalliques, et qui diffèrent au moins quant à l'indice de réfraction, sont formées de manière à être enchevêtrées de façon continue et tridimensionnelle les unes avec les autres.

10. Laser à semi-conducteurs sans danger pour les yeux (30) comprenant un laser à semi-conducteurs (32) et un diffuseur transmettant la lumière (31), **caractérisé en ce que** ledit diffuseur transmettant la lumière (31) comprend un corps solidifié dans lequel deux phases ou plus d'un oxyde sélectionné dans un groupe comprenant un oxyde métallique unique et un oxyde métallique complexe, produit à partir de deux types ou plus d'oxydes métalliques, et qui diffèrent au moins quant à l'indice de réfraction sont formées de manière à être enchevêtrées de façon continue et tridimensionnelle les unes avec les autres.
